# EUROPEAN PATENT SPECIFICATION

(11) **EP 3 193 572 B1**
(45) Date of publication and mention of the grant of the patent: **22.03.2023**
(21) Application number: 17151516.6
(22) Date of filing: 13.01.2017
(51) Int. Cl.: H05K 7/20, H01L 23/44

(54) **IMMERSION COOLING OF POWER CIRCUIT**
TAUCHKÜHLUNG EINER LEISTUNGSSCHALTUNG
REFROIDISSEMENT DE CIRCUIT D'ALIMENTATION PAR IMMERSION

(30) Priority: 15.01.2016 US 201614996472
(43) Date of publication of application: 19.07.2017
(73) Proprietor: Hamilton Sundstrand Corporation, Charlotte, NC 28217 (US)
(72) Inventor: SWENSON, Josh C., Rockford, IL Illinois 61107 (US); MILLER, Christian, Beloit, WI Wisconsin 53511 (US); COONEY, Robert C., Janesville, WI Wisconsin 53546 (US)
(74) Representative: Dehns

(56) References cited:
- US-A1- 2007 034 360
- US-A1- 2008 116 568

## Description

### BACKGROUND OF THE INVENTION

This application relates to immersion cooling of power electronic circuits.

Modern systems are becoming more and more complex and, as a result, complex electrical controls are provided for many such systems. One example system would be aerospace equipment, such as an aircraft.

Control modules for such system often include a motherboard and a plurality of line removable modules ("LRMs") or other circuit boards. One particular type of LRM carries a number of power transistors forming solid state power controllers ("SSPC"). Power transistors have unique cooling challenges.

One known type of power transistors is a metal oxide field effect transistor ("MOSFET"). Although MOSFETs are mentioned, other types of solid state power controllers also raise similar challenges.

Modern control modules may include a very high number of such transistors and electronic controls. The heat generated by these transistors raises challenges with cooling.

Solid state power controllers are subject to transient heat loss due to a number of reasons, including load in-rush currents, fly back when inductive load currents are braked, lightning strikes, overcurrent faults that must be carried for a short period of time prior to turning the SSPC off, etc.

In general, fluid immersion cooling for control circuits have surrounded the entire control module. This raises challenges, as a designer of modern control modules would like to be able to tailor a particular combination of motherboard and circuit boards. Further, when the entire control module is surrounded by cooling fluid, it is difficult to replace any one LRM. Fluid cooling circuits typically include a hermetic seal and, thus, are not prone to easy repair.

A cooling arrangement having the features of the preamble of claim 1 is disclosed in US 2001/034360 A1. A further cooling arrangement as disclosed in US 2008/116568 A1.

### SUMMARY OF THE INVENTION

The present arrangement provides a cooling arrangement as set forth in claim 1.

These and other features may be best understood from the following drawings and specification.

### BRIEF DESCRIPTION OF THE DRAWINGS

Figure 1 shows an example control module.
Figure 2 shows a circuit board within the Figure 1 control module.
Figure 3 shows a first embodiment of the invention.
Figure 4 shows an alternative circuit board.
Figure 5 shows a control module utilizing the Figure 4 embodiment.
Figure 6 shows a feature in accordance with the invention.

### DETAILED DESCRIPTION

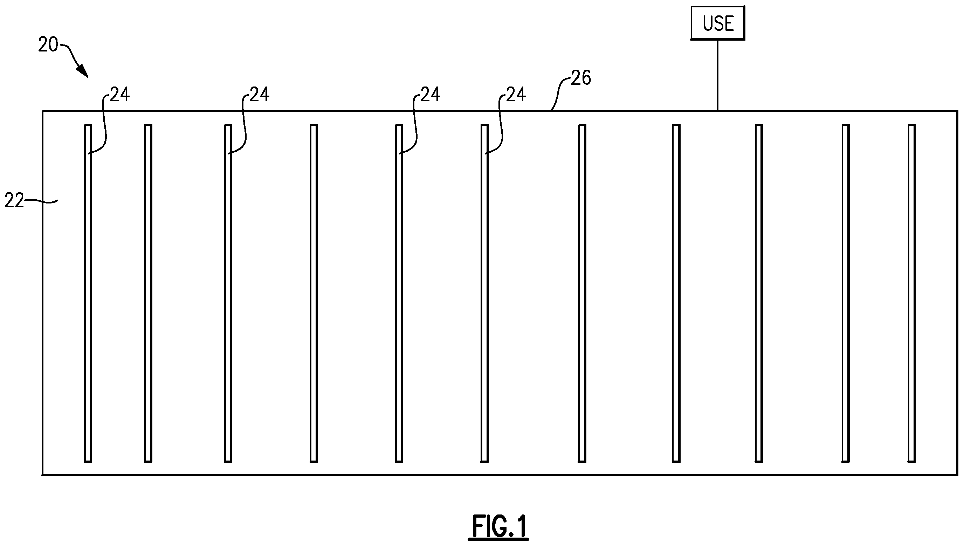

Figure 1 shows a control module 20 including a motherboard 22 and a plurality of removable circuit boards 24. The module 20 communicates control signals to and from a use, such as a system on an aircraft. Boards 24 may be LRMs, but other board types may be used. As known, the boards are electrically connected to the motherboard. An outer housing 26 surrounds the boards 22 and 24. Of course, this view is highly schematic.

As mentioned above, it would be desirable to be able to freely replace the circuit boards 24 on the motherboard 22 to achieve tailored control features for a particular system. Also, some replacement may be required for maintenance purposes. In addition, it is desirable to provide cooling for elements on the circuit boards 24. This becomes particularly valuable if the circuit boards are power distribution circuits carrying power transistors.

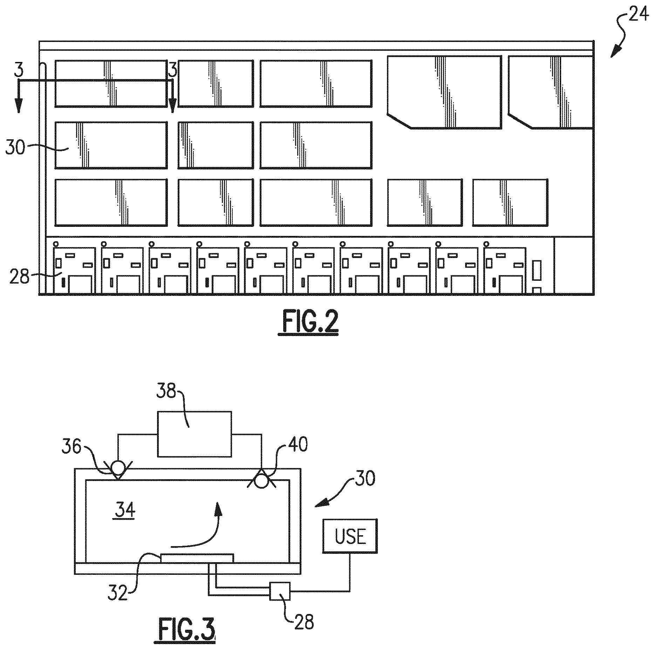

Figure 2 shows a circuit board embodiment 24. As shown, control circuits or switches 28 communicate with transistors in an enclosure 30. The enclosures 30 each surround an individual power transistor or group of power transistors and/or other components that can benefit from additional cooling. In an embodiment the board 24 has connections to be secured to motherboard 22.

Figure 3 shows a first embodiment of the invention wherein a power transistor 32 is mounted within the enclosure 30. Internal chamber 34 is filled with a dielectric cooling fluid. As shown by the curved line, fluid flowing adjacent to the power transistor 32 is heated and flows away, towards the enclosure wall, where it may dissipate heat to the outer environment.

As mentioned above, much of the heat generated by the transistor 32 may be transient. As the fluid absorbs this heat, the fluid expands such that the pressure within the chamber 34 rises. Pressure relief valve 36 allows fluid to then flow outward of the enclosure. A holding container 38 is shown schematically along with a return inlet 40. Once the fluid within chamber 34 cools, the fluid returns from holding chamber 38 into inlet 40. In this manner, the enclosure 30 facilitates handling an expanding fluid. In some embodiments the fluid may boil as result of absorbing the heat, increasing the pressure and assisting heat transfer.

As shown in Figures 3, switches work with the transistor 32 to communicate signals to a use, typically through the motherboard.

With this embodiment, individual line removable modules 24 may be removed from a control module 20 without the complexity of removing the cooling liquid from the enclosure. Also, individual transistors or groups of transistors, and the associated enclosures, may be removed from the circuit board 24 for replacement or repair.

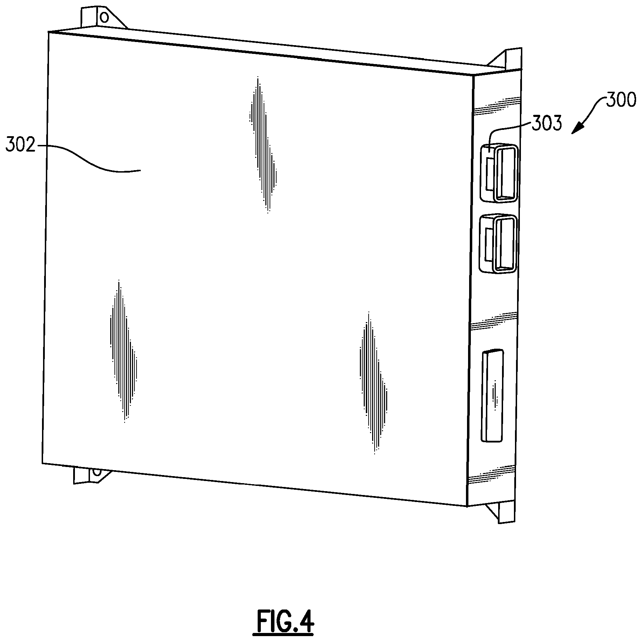

Figure 4 shows another embodiment 300 wherein an entire circuit board 24 is placed within an enclosed immersion cooling housing or enclosure 302. Housing 302 may be provided with heat transfer surfaces on its outer periphery, such as roughened surface or provided with other heat transfer enhancing features such as fins, etc. The enclosure is filled with dielectric cooling fluid and the expansion features of Figure 3 is applied to the entire housing. Of course, appropriate electrical connection shown at 303 extends outwardly of the enclosure.

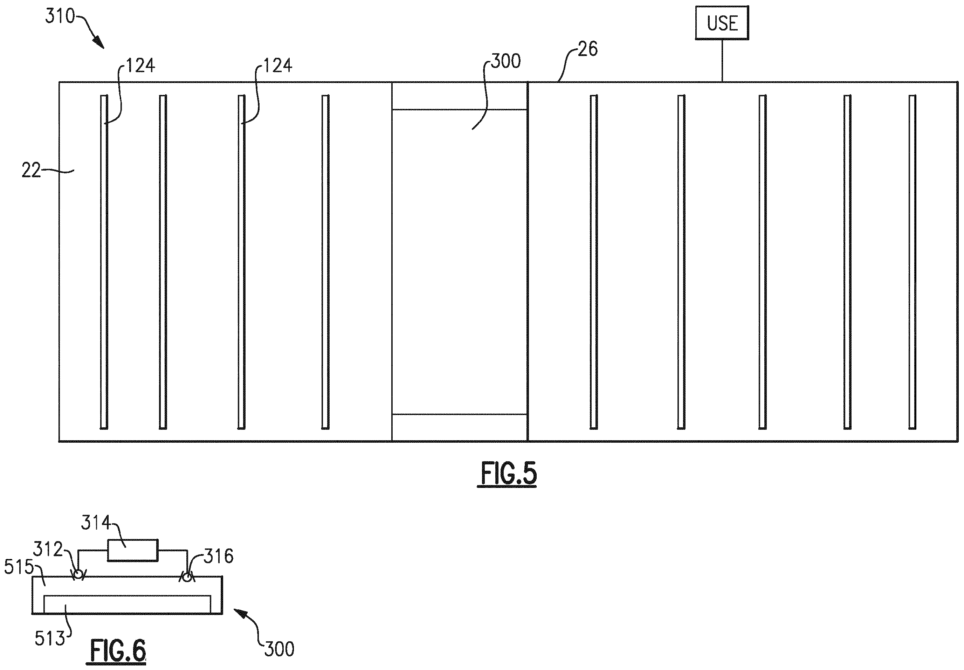

Figure 5 shows a control module 310 having a motherboard 22, a plurality of removable circuit boards 124, which are not provided with immersion cooling, and an enclosed circuit board 300 as shown in Figure 4. Again, the module 310 communicates with a use.

The enclosed circuit board 300 is illustrated in Figure 6, wherein the board 513 is received within a fluid 515, with a pressure relief valve 312 leading to a holding container 314, and an inlet 316. This embodiment will operate to allow expansion of the fluid, and movement of the fluid outwardly of the enclosure should it exceed a predetermined pressure. As such, it operates similar to the Figure 3 embodiment.

In sum, a control module 20, 310 has a motherboard 22 and a plurality of removable circuit boards 24/124/300. At least one of the circuit boards is provided with immersion cooling of an electronic component surrounded by an enclosure that does not enclose others of the plurality of circuit boards.

In embodiments, a circuit board 24/300 has a plurality of electronic components, with an immersion cooling fluid within an enclosure 30/302, such that the circuit board and enclosure can be removed or inserted as a unit into a motherboard without releasing the fluid from the enclosure.

Providing the enclosed cooling facilitates the specific tailoring of the circuit boards 24 or 300. Further, this arrangement facilitates the replacement or repair of individual line removable modules or circuits.

The assembly can facilitate the tailoring of a combination of boards. Typically, a system would have a number of different module/board types such as a power supply, microprocessor, discrete I/O communications, and SSPC modules. As different customers have different numbers and types of loads to be controlled, a mix of modules can be tailored to particular needs. For example, one customer may need several low current DC SSPCs while another might need a mix of AC and DC of various load currents.

It is desirable to be able to have high loss boards (high current especially AC) be specially cooled while the rest of the system be traditional boards. This disclosure achieves such a goal.

Although an embodiment of this invention has been disclosed, a worker of ordinary skill in this art would recognize that certain modifications would come within the scope of this invention. For that reason, the following claims should be studied to determine the true scope and content of this invention.

## Claims

1. A cooling arrangement comprising:
a circuit board (24; 124; 300; 513);
a plurality of electronic components (32) in operable communication with the circuit board (24; 124; 300; 513); and
an enclosure (30) attached to the circuit board (24; 124; 300; 513) being configured to retain a fluid around at least one of the plurality of electronic components (32), said circuit board (24; 124; 300; 513) with the enclosure (30) attached thereto being removably connectable to a motherboard (22);
wherein said enclosure (30) is provided with a feature to allow expansion of a fluid within said enclosure (30);
**characterised by** further comprising:
a pressure relief valve (36; 312) that allows fluid to move outwardly of a chamber (34) surrounding said at least one of the plurality of electronic components (32); and
downstream of said pressure relief valve (36; 312), a holding container (38, 314) and a return inlet (40, 316) to the chamber (34), whereby fluid may return from the holding chamber (38; 314) into the inlet (40; 316) once the fluid within the chamber (34) cools.

2. The cooling arrangement as set forth in claim 1, wherein at least one of the plurality of said electronic components (32) is a transistor (32).

3. The cooling arrangement as set forth in claim 1, wherein said plurality of said electronic components (32) includes at least one power transistor (32) and at least one control circuit, and said enclosure (30) enclosing said at least one power transistor (32), said at least one control circuit being outside said enclosure (30).

4. The cooling arrangement as set forth in claim 3, wherein there are a plurality of said transistors (32) and a plurality of enclosures (30) each enclosing one of said plurality of transistors (32), with a plurality of control circuits positioned outside of said plurality of enclosures (30).

5. The cooling arrangement as set forth in claim 1, wherein said plurality of electronic components (32) includes a transistor (32) and a control circuit received within said enclosure.

6. A control module comprising:
a motherboard (22);
a plurality of removable circuit boards (124; 300); and
a cooling arrangement as set forth in claim 1 for at least one of said circuit boards (300).

7. The control module as set forth in claim 6, wherein said at least one of said circuit boards (24; 124) has at least one power transistor (32) and at least one control circuit, and said enclosure (30) enclosing said at least one power transistor (32), said at least one control circuit being outside said enclosure.

8. The control module as set forth in claim 6, wherein there are a plurality of said transistors (32) and a plurality of enclosures (30) each enclosing one of said plurality of transistors (32), with a plurality of control circuits positioned outside of said plurality of enclosures.

9. The control module as set forth in claim 6, wherein said at least one of said circuit boards (24; 124; 300) is enclosed entirely in said enclosure (30; 134) and at least one circuit board (24; 124; 300) including a transistor (32) and a control circuit all received within said enclosure (30), with others of said plurality of circuit boards being outside said enclosure.

## Patentansprüche

1. Kühlanordnung, Folgendes umfassend:
eine Schaltplatte (24; 124; 300; 513);
eine Vielzahl elektronischer Komponenten (32) in betriebsfähiger Kommunikation mit der Schaltlatte (24; 124; 300; 513); und
eine Umhüllung (30), die an der Schaltplatte (24; 124; 300; 513) angebracht ist und dazu konfiguriert ist, ein Fluid um mindestens eine der Vielzahl elektronischer Komponenten (32) zurückzuhalten, wobei die Schaltplatte (24; 124; 300; 513) mit der daran angebrachten Umhüllung (30) entfernbar mit einer Hauptplatine (22) verbindbar ist;
wobei die Umhüllung (30) mit einem Merkmal versehen ist, um eine Ausdehnung eines Fluids innerhalb der Umhüllung (30) zu ermöglichen;
**dadurch gekennzeichnet, dass** sie ferner Folgendes umfasst:
ein Druckentlastungsventil (36; 312), das es ermöglicht, dass sich Fluid aus einer Kammer (34) nach außen bewegt, die die mindestens eine der Vielzahl elektronischer Komponenten (32) umgibt; und
stromabwärts des Druckentlastungsventils (36; 312), einen Aufnahmebehälter (38, 314) und einen Rücklaufeinlass (40, 316) zu der Kammer (34), wodurch Fluid von der Aufnahmekammer (38; 314) in den Einlass (40; 316) zurücklaufen kann, sobald sich das Fluid innerhalb der Kammer (34) abkühlt.

2. Kühlanordnung nach Anspruch 1, wobei mindestens eine der Vielzahl der elektronischen Komponenten (32) ein Transistor (32) ist.

3. Kühlanordnung nach Anspruch 1, wobei die Vielzahl der elektronischen Komponenten (32) mindestens einen Leistungstransistor (32) und mindestens eine Steuerschaltung beinhaltet und die Umhüllung (30) den mindestens einen Leistungstransistor (32) umhüllt, wobei sich die mindestens eine Steuerschaltung außerhalb der Umhüllung (30) befindet.

4. Kühlanordnung nach Anspruch 3, wobei eine Vielzahl der Transistoren (32) und eine Vielzahl der Umhüllungen (30) vorhanden sind, die jeweils einen der Vielzahl von Transistoren (32) umhüllen, wobei eine Vielzahl von Steuerschaltungen außerhalb der Vielzahl von Umhüllungen (30) positioniert ist.

5. Kühlanordnung nach Anspruch 1, wobei die Vielzahl elektronischer Komponenten (32) einen Transistor (32) und eine Steuerschaltung beinhaltet, die innerhalb der Umhüllung aufgenommen sind.

6. Steuermodul, Folgendes umfassend:
eine Hauptplatine (22);
eine Vielzahl entfernbarer Schaltplatten (124; 300); und
eine Kühlanordnung nach Anspruch 1 für mindestens eine der Schaltplatten (300).

7. Steuermodul nach Anspruch 6, wobei die mindestens eine der Schaltplatten (24; 124) mindestens einen Leistungstransistor (32) und mindestens eine Steuerschaltung aufweist und die Umhüllung (30) den mindestens einen Leistungstransistor (32) umhüllt, wobei sich die mindestens eine Steuerschaltung außerhalb der Umhüllung befindet.

8. Steuermodul nach Anspruch 6, wobei eine Vielzahl der Transistoren (32) und eine Vielzahl der Umhüllungen (30) vorhanden sind, die jeweils einen der Vielzahl von Transistoren (32) umhüllen, wobei eine Vielzahl von Steuerschaltungen außerhalb der Vielzahl von Umhüllungen positioniert ist.

9. Steuermodul nach Anspruch 6, wobei die mindestens eine der Schaltplatten (24; 124; 300) vollständig in der Umhüllung (30; 134) umhüllt ist und mindestens eine Schaltplatte (24; 124; 300), die einen Transistor (32) und eine Steuerschaltung beinhaltet, ganz innerhalb der Umhüllung (30) umhüllt ist, wobei sich andere der Vielzahl von Schaltplatten außerhalb der Umhüllung befinden.

## Revendications

1. Agencement de refroidissement comprenant :
une carte de circuit (24 ; 124 ; 300 ; 513) ;
une pluralité de composants électroniques (32) en communication fonctionnelle avec la carte de circuit (24 ; 124 ; 300 ; 513) ; et
un boîtier (30) fixé à la carte de circuit (24 ; 124 ; 300 ; 513) étant configurée pour retenir un fluide autour d'au moins l'un de la pluralité de composants électroniques (32), ladite carte de circuit (24 ; 124 ; 300 ; 513) avec le boîtier (30) fixé à celui-ci pouvant être connecté de manière amovible à une carte mère (22) ;
dans lequel ledit boîtier (30) est pourvu d'une fonctionnalité pour permettre la dilatation d'un fluide à l'intérieur dudit boîtier (30) ;
**caractérisé en ce qu'**il comprend en outre :
une soupape de surpression (36 ; 312) qui permet au fluide de se déplacer vers l'extérieur d'une chambre (34) entourant ledit au moins un de la pluralité de composants électroniques (32) ; et
en aval de ladite soupape de surpression (36 ; 312), un récipient de retenue (38, 314) et une entrée de retour (40, 316) vers la chambre (34), moyennant quoi le fluide peut retourner de la chambre de retenue (38 ; 314) vers l'entrée (40 ; 316) une fois que le fluide à l'intérieur de la chambre (34) se refroidit.

2. Agencement de refroidissement selon la revendication 1, dans lequel au moins l'un de la pluralité desdits composants électroniques (32) est un transistor (32).

3. Agencement de refroidissement selon la revendication 1, dans lequel ladite pluralité desdits composants électroniques (32) comporte au moins un transistor de puissance (32) et au moins un circuit de commande, et ledit boîtier (30) renfermant ledit au moins un transistor de puissance (32), ledit au moins un circuit de commande étant à l'extérieur dudit boîtier (30).

4. Agencement de refroidissement selon la revendication 3, dans lequel il y a une pluralité desdits transistors (32) et une pluralité de boîtiers (30) renfermant chacune l'un de ladite pluralité de transistors (32), avec une pluralité de circuits de commande positionnés à l'extérieur de ladite pluralité de boîtiers (30).

5. Agencement de refroidissement selon la revendication 1, dans lequel ladite pluralité de composants électroniques (32) comporte un transistor (32) et un circuit de commande reçu à l'intérieur dudit boîtier.

6. Un module de commande comprenant :
une carte mère (22) ;
une pluralité de cartes de circuit amovibles (124 ; 300) ; et
un agencement de refroidissement selon la revendication 1 pour au moins l'une desdites cartes de circuit (300).

7. Module de commande selon la revendication 6, dans lequel ladite au moins une desdites cartes de circuit (24 ; 124) a au moins un transistor de puissance (32) et au moins un circuit de commande, et ledit boîtier (30) renfermant ledit au moins un transistor de puissance (32), ledit au moins un circuit de commande étant à l'extérieur dudit boîtier.

8. Module de commande selon la revendication 6, dans lequel il y a une pluralité desdits transistors (32) et une pluralité de boîtiers (30) renfermant chacune l'un de ladite pluralité de transistors (32), avec une pluralité de circuits de commande positionnés à l'extérieur de ladite pluralité de boîtiers.

9. Module de commande selon la revendication 6, dans lequel ladite au moins une desdites cartes de circuit (24 ; 124 ; 300) est entièrement enfermée dans ledit boîtier (30 ; 134) et au moins une carte de circuit (24 ; 124 ; 300) comportant un transistor (32) et un circuit de commande tous reçus à l'intérieur dudit boîtier (30), avec d'autres de ladite pluralité de cartes de circuit étant à l'extérieur dudit boîtier.
